# EUROPEAN PATENT SPECIFICATION

(11) **EP 2 841 996 B1**
(45) Date of publication and mention of the grant of the patent: **30.12.2020**
(21) Application number: 13712509.2
(22) Date of filing: 14.03.2013
(51) Int. Cl.: G03F 7/20, G02B 26/08, G02B 27/00, G02B 17/06, G21K 1/06, G02F 1/01, G02B 5/08

(54) **OPTICAL ELEMENTS COMPRISING MAGNETOSTRICTIVE MATERIAL**
OPTISCHE ELEMENTE ENTHALTEND MAGNETOSTRIKTIVES MATERIAL
ÉLÉMENTS OPTIQUES COMPRENANT UN MATERIAU MAGNETOSTRICTIF

(30) Priority: 27.04.2012 DE 102012207003; 27.04.2012 US 201261639532 P
(43) Date of publication of application: 04.03.2015
(73) Proprietor: Carl Zeiss SMT GmbH, 73447 Oberkochen (DE)
(72) Inventor: HUBER, Peter, 89233 Holzschwang (DE); DIER, Oliver, 73466 Lauchheim (DE)
(74) Representative: Kohler Schmid Möbus Patentanwälte
(86) International application number: PCT/EP2013/055235
(87) International publication number: WO 2013/160008

(56) References cited:
- WO-A1-2007/033964
- DE-A1-102010 039 930
- JP-A- 2010 256 305
- US-A1- 2006 018 045
- US-A1- 2009 141 378

## Description

### Background of the Invention

The invention relates to an optical element, comprising a substrate, a reflective coating, and at least one active layer comprising a magnetostrictive material. The invention also relates to such an optical element wherein the reflective coating, in particular for the reflection of EUV radiation, comprises a plurality of layer pairs having alternate layers composed of a high refractive index layer material and a low refractive index layer material. The invention furthermore relates to an optical arrangement comprising at least one such optical element.

An optical element of this type and an optical arrangement of this type have been disclosed by US 2006/0018045 A1 and WO 2007/033964 A1.

Reflective optical elements are used for example in photolithography, in particular in EUV lithography, where they are typically used in an illumination system or a projection system for guiding and shaping illumination or projection radiation serving for exposing a substrate for the production of integrated circuits. However, reflective optical elements can also be used in so-called catadioptric projection lenses which are operated with radiation in the UV wavelength range.

An optical element which is reflective to EUV radiation, for the case where it is intended to be used with comparatively small angles of incidence relative to the substrate normal, has a reflective multilayer coating applied to a substrate and having a plurality of layer pairs, wherein the layer pairs have alternate layers composed of a high refractive index layer material and a low refractive index layer material (relative to the high refractive index layer material).

As a result of process fluctuations in the manufacture of reflective optical elements, but also as a result of different operating states (e.g. different illumination settings), it may be necessary to correct an individual reflective optical element, parts of the EUV lithography apparatus, e.g. the projection optical unit, or the EUV lithography apparatus overall in order to improve the optical properties e.g. with regard to wavelength, angle dependence, phase angle, wavefront and/or temperature distribution.

For this purpose, it is possible to use magnetostrictive materials in which, by means of an external magnetic field, the Weiss domains are altered in terms of the relative size with respect to one another or (at very high field strengths) the orientation of the magnetization is rotated and a change in the shape of the material is thus obtained, the volume of the material typically remaining almost unchanged. There is both positive magnetostriction (e.g. in the case of iron) and negative magnetostriction (e.g. in the case of nickel). Materials having positive magnetostriction expand in the direction of the field lines of the applied magnetic field (and contract perpendicularly thereto). Materials having negative magnetostriction contract in the direction of the applied field and expand perpendicularly thereto. This effect can be used for altering the layer thickness of the magnetostrictive layer.

US 2006/0018045 A1 discloses a mirror arrangement comprising a substrate, the front side of which has a mirror surface and on the rear side of which is arranged an actuator arrangement for producing a deformation of the substrate, said actuator arrangement having at least one active layer. The active layer arranged on the rear side of the substrate can comprise, for example, a piezoelectric or a magnetostrictive material. By means of targeted, local driving of the active layer, the mirror arrangement, more precisely the substrate, can be deformed in a targeted manner, whereby the optical properties of the optical element are intended to be improved.

WO 2007/033964 A1 describes an adaptive optical element comprising a main body and at least one active layer composed of a magnetostrictive material, for example, said at least one active layer being connected to the main body and being deformable by the application of a field. The active layer can serve as a correction layer and be designed for the at least local and at least partial correction of at least one defect of the optical element by the application of the field. If such an optical element is introduced into a magnetic field which is generated e.g. by a corresponding coil arrangement, local geometrical defects in the optical element can be corrected by means of the local deformation of the active layer in accordance with the strength and direction of the field lines of the magnetic field.

DE 10 2010 039930 A1 discloses a projection exposure apparatus for semiconductor lithography that includes optical elements, wherein at least one of the optical elements includes a mechanism for contactlessly producing electric currents in the optical element to heat the at least one optical element at least in regions.

US 2009/141378 A1 discloses an optical element, comprising: a substrate, a magnetostrictive film arranged on the substrate, a film thickness of the magnetostrictive film varying in accordance with intensity of a magnetic field, and a reflection film arranged on the magnetostrictive film. The film thickness of the magnetostrictive film can be controlled by a control mechanism for controlling the magnetic field generated by a plurality of magnetic field generation parts that include a coil.

### Object of the Invention

It is an object of the invention to improve the optical properties of reflective optical elements and of an optical arrangement comprising at least one such optical element.

### Subject Matter of the Invention

This object has been achieved by providing an optical element according to claims 1 and 7.

The magnetizable layer can be magnetized at least in a partial region. A layer which is magnetized at least in a partial region is understood, within the meaning of this application, to be a layer which is magnetized at least in the partial region by the application of a strong (external) field, i.e. whose elementary magnets are oriented by the application of said field, such that a magnetic field having a desired field distribution is established in said layer.

The inventors have recognized that a local variation of the geometry or of the surface shape of the reflective coating or of the substrate surface by means of a magnetostrictive layer does not necessarily require a field generating device which makes possible a dynamic correction of wavefront aberrations of the optical elements including in the installed state in an optical arrangement, e.g. in an EUV lithography apparatus. Rather, the provision of at least one layer comprising a permanent-magnetic material on the optical element itself makes it possible to generate a static magnetic field which makes possible a static, local manipulation of the surface shape or of the wavefront of the optical element. With the use of an optical element of this type in an optical arrangement, it is possible, if appropriate, to dispense with the provision of a field generating device (for example in the form of coils or electromagnets), such that the construction thereof is simplified. With the aid of an optical element optimized with regard to the wavefront, imaging aberrations which occur in an optical arrangement into which the optical element is introduced can advantageously be corrected and ideally wholly eliminated.

The static field distribution acts on the layer comprising the magnetostrictive material in order to deform said layer locally or, if appropriate, globally in a desired manner, that is to say to change said layer in particular in terms of thickness, in order to correct wavefront aberrations of the optical element. For this purpose, the permanent-magnetic material has a static magnetization which varies locally or in a location-dependent manner. The resultant static deformation of the active layer remains until the permanent-magnetic layer is re- or demagnetized by the application of a strong magnetic field.

The magnetization of the permanent-magnetic material can advantageously be effected during or after a wavefront measurement, which can be effected, e.g. by means of an interferometric measurement method, in order to produce the desired wavefront correction. It goes without saying that the correction introduced in this case can be directly monitored by an interferometric measurement and, if appropriate, corrected or "erased" by a demagnetization or a remagnetization.

For modifying or changing the wavefront, the active layer is caused to undergo a local or global change in thickness by the magnetic field of the magnetized layer. For this purpose, the magnetized layer can have a locally variable (inhomogeneous) or a locally uniform (homogeneous) magnetic field, depending on what type of deformation of the active layer is desired. Within the meaning of this application, a permanent-magnetic material is understood to be a hard-magnetic material, that is to say a material for which the coercive field strength He is 10³ A/m, preferably 10⁴ A/m.

In one embodiment, the permanent-magnetic material of the magnetized layer is selected from the group: (hard-magnetic) ferrites, samarium-cobalt (SmCo), bismanol, neodymium-iron-boron (NdFeB) and (hard-magnetic) steel. Samarium-cobalt and bismanol are strong, in the case of neodymium-iron-boron a very strong permanent-magnetic material. Bismanol is an alloy composed of bismuth, manganese and ion. With the use of these materials, even small quantities suffice or a small layer thickness of the magnetizable layer arises in order to achieve an intended deformation of the active layer or of the optical element. The permanent-magnetic material can also be carbon-rich steel, hard-magnetic ferrite or some other suitable material.

In a further embodiment, the permanent-magnetic material of the magnetized layer is magnetostrictive. An optical element of this type is particularly simple to produce since the active layer and the magnetized layer can be realized in one and the same layer. In particular, Fe, Ni, Co are appropriate as layer materials which are both permanent-magnetic and have magnetostrictive properties.

If the active layer and/or the magnetizable layer are/is arranged between the reflective coating and the substrate, such an adjacent arrangement of the layers is advantageous since the magnetic field has the highest field strength in the vicinity of the magnetized layer and, consequently, can lead to a sufficient change in thickness of the active layer even in the case of a small thickness. It goes without saying that the magnetized layer can, if appropriate, also be arranged on that side of the substrate which faces away from the reflective coating, even if the influence of the magnetized layer on the active layer turns out to be smaller in this case on account of the larger distance. Since different magnetostrictive materials can have a very different magnetostrictive constant (Δl/l), the (field-free) layer thickness required for a predefined wavefront correction can be very different. The layer thickness of the active layer can therefore be in the range of between a few nanometers and a few tens of micrometers in the case of a predefined maximum possible wavefront correction depending on the maximum possible change in thickness (Δl/l or Δd/d). By way of example, for a wavefront correction of 3 nm, the thickness of the magnetostrictive layer can be between approximately 15 nm and approximately 100 µm.

Since the magnetizable layer and/or the active layer, depending on the type of layer material and the layer thickness, have/has a surface roughness which possibly does not suffice for the direct application of the reflective coating, it is possible, if appropriate, to apply additional smoothing or polishing layers to the magnetizable layer and/or to the active layer. Depending on the roughness, smoothing layers, that is to say layers that reduce the roughness by virtue of application, can be a few nanometers thick, whereas polishing layers, that is to say layers that reduce the roughness by virtue of material removal, can be a few micrometers thick. Depending on the material, the magnetostrictive layer itself is likewise polishable, if appropriate. Moreover, given insufficient adhesion of the magnetostrictive material of the active layer on the substrate, it is possible, if appropriate, to apply an adhesion promoter layer composed of chromium or composed of titanium, for example, wherein typical layer thicknesses of the adhesion promoter layers are generally less than approximately 10 nm.

The scope of the invention also encompasses an optical element of the type mentioned in the introduction wherein at least one active layer is formed within the coating that is in particular reflective to EUV radiation. The optical element comprises, as described above, one or more magnetizable layers comprising or composed of a permanent-magnetic material. If appropriate, the magnetizable layer composed of the permanent-magnetic material can likewise be arranged within the reflective coating, preferably adjacent to the active layer. This is advantageous in particular in the case of permanent-magnetic materials which have a comparatively low absorption coefficient with high remanence, e.g. in the case of NdFeB.

By arranging at least one active layer within the reflective coating (that is to say within the layer stack or the layer arrangement having the plurality of layer pairs), it is possible advantageously to influence further optical properties of the optical element, in particular the wavelength-dependent reflectivity of the reflective coating or the phase at the transition (interface) with respect to the (vacuum) surroundings. The active layer can be an additional layer arranged between the alternate layers composed of a high refractive index layer material and a low refractive index layer material. If appropriate, one of the alternate layers itself can serve as active layer, that is to say that the layer material of one of the high or low refractive index layers is replaced by the magnetostrictive layer material of the active layer. Preferably, in this case the layer material of a low refractive index layer (absorber layer), for example of a layer composed of molybdenum, can be replaced by a layer composed of a magnetostrictive material.

In one embodiment, the reflective coating has a number N of alternate layers. A first layer of the reflective coating is arranged adjacent to the substrate and an N-th layer of the reflective coating is arranged adjacent to a surface of the optical element facing the environment. At least one active layer is situated between the first and the N-5-th layer of the reflective coating in order to adapt the wavelength-dependent reflection of the reflective coating. As a result of the arrangement of the active layer in the lower or central region of the reflective coating, it is possible to achieve a fundamental change in the line form of the resulting reflectivity curve and, for example, to increase the width of the reflection maximum.

The reflective coating can have in the lower or central region one or more active layers in order to manipulate the form of the reflectivity curve of the reflective coating in a targeted manner, for example with regard to the bandwidth of the wavelength range in which the reflectivity is particularly high. In particular, a local, that is to say location-dependent, fine tuning of the reflective coating and thus of the entire optical element can be performed. The active layer is arranged within the reflective coating typically between two adjacent layer pairs, but it is also possible to arrange the active layer between the two layers of a respective layer pair. The active layer produces an optical path length difference or a phase shift between the layer group arranged above the active layer (in the direction toward the interface between the layer arrangement and the environment) and the layer group provided below the active layer (that is to say in the direction toward the substrate). As a result of the generation of a magnetic field, the thickness of the active layer and thus the change in the reflectivity curve can be adapted in a continuously variable manner.

In a further embodiment, in the case of a reflective coating having a number N of alternate layers, the first of which is arranged adjacent to the substrate and the N-th of which is arranged adjacent to a surface facing the environment, the active layer is arranged between the N-5-th layer and the N-th layer. Such an arrangement of the active layer within the reflective coating makes it possible to influence the phase angle of the electromagnetic wave at the ray entrance surface facing the environment (interface with the vacuum) in a targeted manner. A fine tuning of the spectral position of the maximum reflectivity is thus possible substantially without a change in the reflectivity curve. It goes without saying that in this embodiment, too, the form of the reflectivity curve can be influenced in a targeted manner by one or more active layers provided further below in the coating.

In one development of the abovementioned embodiment, the thickness of the active layer in the field-free state is between a thickness d1 = 0.5 nm and a thickness d2 = 7 nm, preferably between a thickness d1 = 2 nm and a thickness d2 = 4 nm. Within the thickness ranges specified, the active layer acts substantially as a lambda/4 layer, wherein a suitable value for the layer thickness is dependent, inter alia, on the angle of incidence of the impinging radiation. Usually, in the case of (negative and positive) magnetostrictive materials, the change in length Δl/l in the field direction is up to approximately -3 x 10⁻⁵ and up to + 2 x 10⁻² respectively. A few picometers to a maximum of 0.2 nm suffice for influencing the form of the reflectivity curve, wherein positively magnetostrictive materials are particularly advantageous on account of the higher magnetostrictive constants. By varying the layer thickness of the active layer, it is possible to change the reflectivity curve of the reflective coating or of the optical element in terms of width. It is thus also possible to change or adapt the line form of the reflectivity curve, wherein the effect achieved in each case is dependent on the position of the active layer within the layer stack or the reflective coating. For a wavefront correction of the optical element, by contrast, changes in thickness in the range of several nanometers (up to approximately 20 nm) are desirable, which can be achieved by means of an active layer having a larger thickness which is advantageously applied between the substrate and the reflective coating (see above).

It goes without saying that the first and the N-th layer of the reflective coating (which can consist of silicon or molybdenum, for example) need not necessarily directly adjoin the substrate and the interface with the environment, respectively. Rather, in the first case, additional adhesion-promoting, polishing or smoothing layers can be provided between the first layer and the substrate and, in the later case, one or more capping layers can be provided between the N-th layer and the interface, which protect the layers of the reflective coating against oxidation.

Typically, an even number N of layers is provided as a result of the alternating construction of the reflective coating (layers composed of high and low refractive index layer material). However, it is possible, in principle, also to provide an odd number of layers composed of high and low refractive index material, in particular if the total number of layers is sufficiently high (e.g. if the coating has approximately 100 or more layers). The number of alternating layers in the reflective coating in EUV lithography is typically between N= 50 and N= 120 (that is to say between 25 and 60 layer pairs or periods), wherein a smaller number of periods (e.g. 12 to 15 periods) can also be used for broadband coatings. The radiation entrance surface or the surface facing the environment is understood to be that surface of the coating which faces away from the substrate and at which the EUV radiation to be reflected impinges on the optical element.

In one development of the optical element, at least one active layer is provided in all of the layer pairs. An active layer can be arranged between the layer composed of the high refractive index layer material and the layer composed of the low refractive index layer material or can be situated below or above the high or low refractive index layer of the layer pair. Typically, the active layers of the layer pairs or the two or more layer pairs themselves (in the field-free state) have an identical thickness, that is to say that the reflective coating has a periodic structure. The provision of a plurality of active layers inserted into the reflective coating makes it possible to effect a change, more precisely a shift, in the entire reflectivity curve of the reflective coating. By way of example, it is possible in this way to shift the reflectivity curve into the red, that is to say toward higher wavelengths, if the layer thickness of the active layers and thus of the respective layer pairs is increased by the application of a magnetic field.

Since the layer thickness of the active layers can be locally influenced e.g. by electromagnets or, if appropriate, by a permanent-magnetic layer, in the case of a rotationally symmetrical reflective coating it is possible subsequently to adapt the reflectivity curve to the local requirements on the substrate in terms of wavelength and/or with regard to the respective angle of incidence and/or it is possible to correct manufacturing defects of the optical element or of the overall system (the optical arrangement).

In one development, the at least one active layer of a respective layer pair has a thickness of a maximum of 2.5 nm, in particular of a maximum of 1.0 nm in the field-free state. Such an embodiment of the active layer(s) can ensure that the magnetostrictive material, which is more highly absorbent typically by a factor of 10 in comparison with the materials of the high and low refractive index layers, can be incorporated into the reflective coating without the functionality of the reflective coating or the reflectance for EUV radiation being impaired to an excessively great extent in this case. However, the thickness of the layer should also not be chosen to be too small, in order to ensure that the layer material can still be ordered ferromagnetically.

In order to produce a sufficient change in thickness, the layer materials used should have a high magnetostriction. Since the changes in thickness required for the above-described etalon effects or other phase-shifting effects are, if appropriate, in the range of picometers or of angstroms, the layer thicknesses specified above are generally sufficient. Therefore, the advantages of magnetostriction can advantageously also be utilized for layers within the reflective coating.

A further aspect of the invention relates to an optical element of the type mentioned in the introduction which comprises at least one first active layer comprising a material having positive magnetostriction and at least one second active layer comprising a material having negative magnetostriction, wherein the layer thicknesses and the layer materials (or the magnetostrictive constants of the layer materials) of the active layers are chosen such that mechanical stress changes or changes in length of the active layers that are produced by a magnetic field (substantially) mutually compensate for one another. The (positively and negatively magnetostrictive) active layers can be formed in the reflective coating or between the substrate and the reflective coating. They can, if appropriate, also be formed from a permanent-magnetic material or be formed in a layer containing a permanent-magnetic material.

The application of a magnetic field to a (positively or negatively) magnetostrictive material leads both to a change in length or thickness (increase or decrease in thickness) in the field direction and to a corresponding change (decrease or increase in length) of the material transversely with respect to the applied magnetic field, since typically the volume of the material is substantially maintained. In the case of a magnetic field oriented substantially perpendicularly to the coating, the change transversely with respect to the applied magnetic field leads to a change in the layer stress, the latter being unimportant or negligible for many applications. If the change in the layer stress has to be taken into account in specific applications, the layer stress can be manipulated in a targeted manner substantially in two ways: the layer stress is minimized, or the change in length is minimized.

If no change in layer stress is desired, it is possible e.g. to combine two active layers composed of materials having positive and negative magnetostriction such that the change in layer stress of one active layer precisely compensates for the change in stress of the other active layer, wherein the changes in length of the two active layers do not compensate for one another (by virtue of the layer thicknesses being suitably coordinated with the respective magnetostrictive constants). There is an advantageous effect here in that the change in length or the change in stress (to a good approximation) is linearly dependent on the applied field strength, the proportionality factor being given by the magnetostrictive constant (in the field direction or transversely with respect to the field direction) of the respective magnetostrictive material.

If only the layer stress is intended to be changed (without a change in length) by the application of the magnetic field, it is necessary to combine two other active layers (having selected thicknesses and positively and negatively magnetostrictive materials), such that the changes in length brought about by the application of a magnetic field precisely compensate for one another.

In a further embodiment, the magnetostrictive material of the active layer is selected from the group comprising: SeFe₂, TbFe₂, DyFe₂, Terfenol-D (Tb₍ₓ₎ Dy₍₁₋ₓ)Fe₂), galfenol (Ga₍ₓ₎ Fe_{(1-X)}), Ni, Fe, Co, Gd, Er, SmFe₂, Samfenol-D and the compositions thereof. Ni, Fe and Co are chemical elements and SmFe₂ and Samfenol-D (a samarium-dysprosium-iron alloy) are iron compounds which in each case exhibit a negative magnetostrictive effect. The iron compounds SeF₂, TbFe₂, DyFe₂ and, in particular, the alloys Terfenol-D and galfenol have a high positive magnetostrictive effect, that is to say that even small layer thicknesses lead to considerable changes in thickness when a magnetic field is present. Consequently, the active layer can be made comparatively thin with the use of Terfenol-D, galfenol or SmFe₂ or Samfenol-D, such that layers composed of these materials are particularly well suited to being introduced into a reflective coating. It goes without saying that magnetostrictive materials other than those specified above can also be used as active layer, for example the so-called 4f elements or Ni adjacent or related chemical elements.

The scope of the invention furthermore encompasses an optical arrangement, in particular an EUV lithography apparatus or a catadioptric projection lens of a lithography apparatus for UV radiation, comprising at least one optical element as described above. In particular with the use of an optical element comprising a layer composed of a permanent-magnetic material, by virtue of the fact that said layer provides a (static, but if appropriate variable in a location-dependent manner) magnetic field, it is no longer necessary to incorporate or provide a field generating device (comprising e.g. coils or electromagnets) in the optical arrangement, such that the construction of the optical arrangement is simplified. It goes without saying that, for dynamically adapting the optical properties, if appropriate, even with the use of a permanent-magnetic layer, a field generating unit can be provided in the optical arrangement.

In the case of an optical arrangement comprising optical elements having at least one active layer between substrate and reflective coating and/or within the reflective coating, the advantages which arise are substantially the same as those which arise with the use of the optical element itself. They include, in particular, the capability of influencing the wavefront or the reflectivity curve and the resultant possible fine tuning of the optical element or of the optical arrangement or the defect correction.

In one embodiment of the optical arrangement, the latter comprises a field generating device for generating a magnetic field, which is variable in particular in a location-dependent manner, in the at least one active layer. The field generating device can have, for example, a plurality of individually drivable electromagnets in order to generate a locally varying magnetic field. This makes possible a location-dependent (local) deformation of the active layer which can be used to compensate for fabrication defects of the reflective optical element or of the coating and/or to compensate for stresses of the reflective optical element and/or to compensate for image aberrations that arise during the operation of the lithography apparatus.

In one development, the field generating device is designed for inductively heating the at least one active layer and/or the at least one layer comprising the permanent-magnetic material by generating a temporally periodically variable magnetic field. Said variable magnetic field can be superimposed, in particular, on a static magnetic field which is variable in a location-dependent manner. In particular with the use of a permanent-magnetic or ferromagnetic material on the optical element, the alternating field can be concentrated in a manner similar to that in the case of induction cooking pots and the efficiency of the inductive heating can thus be increased.

Since the strength of the alternating field can also be chosen to be different locally, it is possible to generate eddy currents in the active layer or in the active layers which heat e.g. only those regions of the optical element which are not reached by the EUV radiation impinging on the optical element in the case of a respective illumination setting and are therefore not heated. The inductive heating can lead there to local heating that smoothes possibly existing temperature gradients. This results in a homogenization of the temperature profile in the optical element, which can in turn reduce or even prevent a local deformation of the optical element. As a result, optical aberrations that occur on account of temperature gradients can ideally be completely eliminated.

If the absolute value of the alternating field component of the magnetic field is chosen to be greater than the absolute value of the static (constant) component of the magnetic field, the heating effect can be further reinforced since at least occasionally the sign of the magnetic field changes and the magnetostrictive layer is thus remagnetized, in the case of which additional heat arises. In this case, however, it should be taken into consideration that when the magnetostrictive layer is arranged between substrate and reflective coating, the remagnetization (in the kHz range) can follow the magnetic field and thus the figure, that is to say the surface shape of the substrate at low spatial frequencies, likewise changes in the kHz range.

In one development of the optical arrangement, the field generating device is designed for generating a magnetic field that is periodically variable with a frequency (f) of more than 20 kHz, preferably of more than 60 kHz. The frequency of the temporally variable magnetic field is thus greater than the frequency of the EUV radiation source (operated in pulsed fashion), which is typically a maximum of approximately 20 kHz. What can be achieved in this way even in the case of the remagnetization of the magnetostrictive layer is that the effect of the periodically variable magnetic field (dynamic magnetic field) used for inductive heating, for the pulsed EUV radiation, produces an averaged magnetostrictive change in thickness. It goes without saying that alternatively it is also possible to activate the inductive heating only in pauses in the operation of the optical arrangement, in which no EUV radiation impinges on the optical element. In particular, it is also possible to carry out the inductive heating during the EUV irradiation, but only in time segments that are in each case between two successive pulses of the EUV radiation. Generally, the frequency with which the periodically variable magnetic field is generated should be not more than approximately 200 kHz, in order that the magnetization of the layers can follow the magnetic field.

Further features and advantages of the invention are evident from the following description of exemplary embodiments of the invention, with reference to the figures of the drawing, which show details essential to the invention and from the claims. The individual features can be realized in each case individually by themselves or as a plurality in any desired combination in a variant of the invention while remaining within the scope of the claims.

### Drawings

In the figures
- **Fig. 1**: shows a schematic illustration of an EUV lithography apparatus comprising an illumination system and a projection lens,
- **Fig. 2a-c**: show schematic illustrations of an optical element for the EUV lithography apparatus from figure 1 having a magnetized layer,
- **Fig. 3a**: shows a schematic illustration of an optical element having an active layer arranged centrally in a reflective coating,
- **Fig. 3b**: shows the wavelength-dependent reflectivity R of the optical element from figure 3a for different layer thicknesses of the active layer,
- **Fig. 3c,d**: show further schematic illustrations of an optical element having an active layer arranged within the reflective coating,
- **Fig. 4**: shows a schematic illustration of an optical element having a reflective coating in which an active layer is applied between each layer composed of high and low refractive index material,
- **Fig. 5**: shows a schematic illustration of an optical element having two active layers whose layer stresses mutually compensate for one another when a magnetic field is applied, and
- **Fig. 6**: shows a schematic illustration of an optical element having two active layers whose changes in length mutually compensate for one another when a magnetic field is applied.

In the following description of the drawings, identical or functionally identical component parts are designated by identical reference signs.

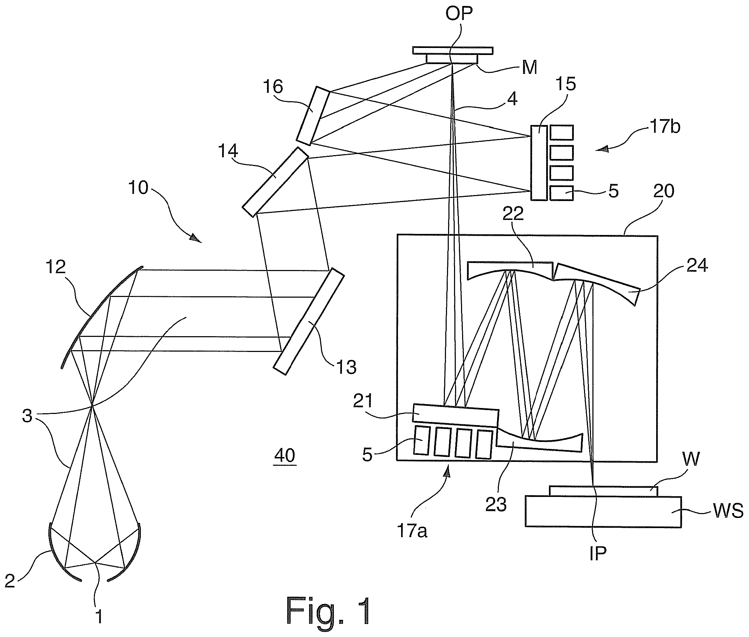

**Figure 1** schematically shows an optical arrangement in the form of an EUV lithography apparatus 40. The latter comprises an EUV light source 1 for generating EUV radiation having a high energy density in an EUV wavelength range below 50 nm, in particular between approximately 5 nm and approximately 15 nm. The EUV light source 1 can be embodied, for example, in the form of a plasma light source for generating a laser-induced plasma or as a synchrotron radiation source. In the former case, in particular, it is possible, as shown in figure 1, to use a collector mirror 2 in order to concentrate the EUV radiation from the EUV light source 1 to form an illumination ray 3 and to further increase the energy density in this way. The illumination ray 3 serves for illuminating a structured object M by means of an illumination system 10, which has four reflective optical elements 13 to 16 in the present example.

The structured object M can be, for example, a reflective mask having reflective and non-reflective or at least less reflective regions for producing at least one structure on the object M. Alternatively, the structured object M can be a plurality of micromirrors which are arranged in a one- or multidimensional arrangement and which are movable, if appropriate, about at least one axis in order to set the angle of incidence of the EUV radiation 3 on the respective mirror.

The structured object M reflects part of the illumination ray 3 and shapes a projection ray 4, which carries the information about the structure of the structured object M and which is radiated into a projection lens 20, which produces an imaging of the structured object M or of a respective partial region thereof on a substrate W. The substrate W, for example a wafer, comprises a semiconductor material, e.g. silicon, and is arranged on a mount, which is also designated as wafer stage WS.

In the present example, the projection lens 20 has four reflective optical elements 21 to 24 (mirrors) in order to produce an image of the structure present at the structured object M on the wafer W. The number of mirrors in a projection lens 20 is typically between four and eight, but it is also possible, if appropriate, to use only two mirrors.

In order to achieve a high imaging quality during the imaging of a respective object point OP of the structured object M onto a respective image point IP on the wafer W, extremely stringent requirements are to be made of the surface shape of the reflective optical elements (mirrors) 21 to 24 and the position or the orientation of the optical elements 21 to 24 with respect to one another or relative to the object M and to the substrate W also requires a precision in the nanometers range.

In order to combat imaging aberrations within the projection lens 20 as a result of, for example, an incorrect orientation of the optical elements 21 to 24, as a result of fabrication defects and/or as a result of temperature-dictated deformations during operation, the undesirable deformation of the optical elements 21 to 24 can be counteracted by means of a field generating device 17a, which typically comprises a plurality of electromagnets 5 for generating a magnetic field that is variable in a location-dependent manner. Figure 1 illustrates the field generating device 17a only in the region of the optical element 21 of the projection lens 20, but it is also possible, in principle, to provide a respective field generating device for a plurality or else for all of the optical elements 21 to 24. It goes without saying that a field generating device 17b having electromagnets 5 can also be arranged at the optical elements 13 to 16, such that corrections can also be made in the illumination system 10.

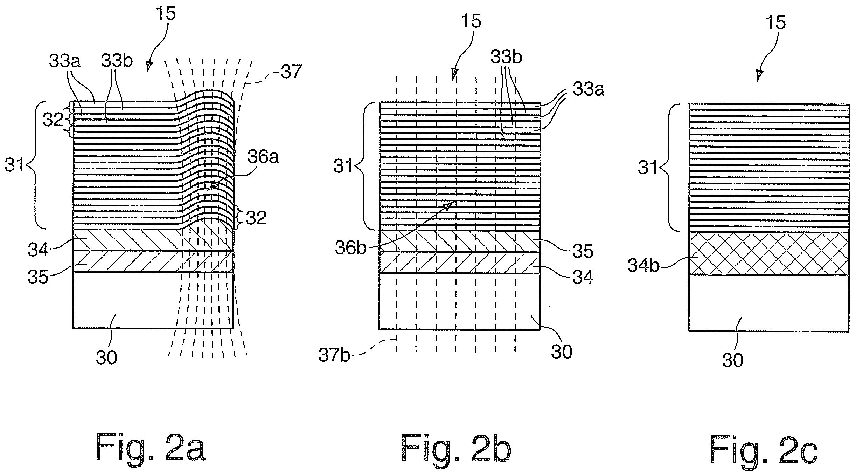

In order to influence the optical properties of, for example, the third optical element 15 of the illumination system 10 by means of the applied magnetic field, it has to comprise a magnetostrictive material. **Figure 2a** shows the construction of the optical element 15 in a schematic illustration. The optical element 15a comprises a substrate 30 composed of a material having a low coefficient of thermal expansion, e.g. Zerodur®, ULE® or Clearceram® and a coating 31 that is reflective to the EUV radiation. The reflective coating 31 has a number of layer pairs 32 having alternate layers composed of a high refractive index layer material 33a and a low refractive index layer material 33b. The number of high and low refractive index layers 33a, 33b illustrated in figure 2a and also in all further figures should be understood merely as illustrative. Typically, optical elements have between approximately 30 and approximately 60 layer pairs composed of high and low refractive index layer material 33a, 33b. However, deviations therefrom in the number of layer pairs 32 can also occur occasionally. The typically periodic construction of the reflective coating 31 (that is to say having layer pairs 32 of identical thickness) makes it possible to reflect short-wave EUV radiation having a wavelength in the nm range (e.g. at 13.5 nm). In this case, the layers 33a composed of the high refractive index material are silicon and the layers 33b composed of the low refractive index material are molybdenum. Depending on the wavelength of operation, other material combinations such as e.g. molybdenum and beryllium, ruthenium and beryllium or lanthanum and B₄C are likewise possible. If the reflective optical element 15 is not intended to be operated in the EUV lithography apparatus shown in figure 1, but rather with imaging light at wavelengths of more than 150 nm, the reflective coating 31 generally likewise has a plurality of individual layers which consist alternately of materials having different refractive indexes, but in this case it is also possible, if appropriate, to dispense with a multilayered coating, that is to say that the reflective coating can be formed only from a single layer (e.g. composed of aluminum).

In addition to the individual layers 33a, 33b described, the reflective coating 31 can also comprise intermediate layers for preventing diffusion or capping layers for preventing oxidation and corrosion. The illustration of such auxiliary layers in the figures has been omitted. In the example illustrated, the mirror 1 has a plane surface, but the latter was chosen merely to simplify the illustration. The substrate 30 or the mirror 15 can also have a curved surface shape. By way of example, concave surface shapes and convex surface shapes are possible. The surface shapes can be both spherical and aspherical and without rotational symmetry (freeform).

The optical element 15 furthermore has an active layer 34 composed of a magnetostrictive material and a magnetizable layer 35, or in the present example a layer 35 magnetized in a partial region, composed of a permanent-magnetic material. The active layer 34 and the magnetized layer 35 are arranged between the reflective coating 31 and the substrate 30, wherein the magnetized layer 35 directly adjoins the substrate 30.

In the present example, the active layer 34 of the optical element 15 consists of the highly (positively) magnetostrictive alloy Terfenol-D (Tb₍ₓ₎ Dy₍₁₋ₓ₎ Fe₂), which leads to considerable changes in thickness of the active layer 34 even in the case of a small layer thickness and when a magnetic field is present, cf. figure 2a. However, other positively or negatively magnetostrictive materials such as e.g. galfenol (Ga₍ₓ₎ Fe₍₁₋ₓ₎), SeFe₂, TbFe₂, DyFe₂, Ni, Fe, Co, Gd, Er, SmFe₂, Samfenol-D and the compositions thereof are also appropriate as magnetostrictive substances for the active layer 34.

In the present example, the magnetizable layer 35 of the optical element 15 consists of neodymium-iron-boron (NdFeB), which exhibits a very strong (permanent) magnetic effect. However, the permanent-magnetic material can also be, for example, ferrites, SmCo (samarium-cobalt), Bismanol or hard-magnetic steel. In order to produce the magnetization of the permanent-magnetic material, the optical element 15 is exposed to a magnetic field that is high enough to provide the permanent-magnetic material and thus the magnetizable layer 35 with a permanent, static magnetization.

In the present example, the magnetized layer 35 of the optical element 15 has been magnetized only locally, for which reason it leads to the generation of a magnetic field 36a only in a delimited partial region (illustrated here on the right-hand side of the optical element 15). Said magnetic field 36a brings about a local deformation of the active layer 34 or of the reflective coating 31 concomitantly deforming (passively) with the latter. In the case of figure 2a, positive magnetostriction occurs in the active layer 34, that is to say that the active layer 34 expands in the region of the magnetic field 36 in the direction of the field lines 37. It goes without saying that materials having negative magnetostriction can also be chosen, that is to say materials which contract parallel to the field lines 37 of the magnetic field 36a.

The local deformation of the active layer 34 advantageously makes it possible to manipulate the wavefront reflected by the optical element 15a or else to influence layer stresses that occur, if appropriate, at the optical element 15 or in the reflective coating 31 (see below).

**Figure 2b** shows an optical element 15 which is constructed substantially like the optical element 15 from figure 2a and which can likewise be used in the EUV lithography apparatus 40 from figure 1. In the case of the optical element 15 from figure 2b, in contrast to the optical element 15 from figure 2a, the active layer 34 is arranged directly adjacent to the substrate 30 and the magnetized layer 35 is arranged directly adjacent to the reflective coating 31, that is to say that the layer order thereof is interchanged, but both layers 34, 35 are arranged directly adjacent to one another. In principle, additional adhesion layers, smoothing layer, polishing layers, or stress reducing layers or other intermediate layers (not illustrated here) can be provided between the substrate 30 and the reflective coating 31 in the case of all the optical elements 13 to 16 and 21 to 24.

Furthermore, the layer 35 in figure 2b is magnetized completely and uniformly over its entire extent. A homogenous magnetic field 36b having magnetic field lines 36b oriented virtually parallel at least in the region of the optical element 15 is formed as a result. The consequence is that the active layer 34 expands uniformly. It goes without saying that, in the manner described above, a magnetization that is variable virtually arbitrarily in a location-dependent manner can be set in the layer 35 composed of the permanent-magnetic material. **Figure 2c** shows an optical element 15 which is constructed substantially like the optical element 15 from figure 2a and comprises a substrate 30 and a reflective coating 31. In contrast to the previous examples, in the optical element 15 the magnetizable layer is embodied as an active layer 34b, that is to say that the permanent-magnetic material has magnetostrictive properties, such that the active layer and the magnetized layer form a common layer 34b. The active layer and the magnetized layer can thus be produced from the same layer material (for example Fe, Ni, Co). Alternatively, it is also possible to produce a layer having magnetostrictive and permanent-magnetic properties from a mixture or an alloy containing regions (or crystallites/conglomerates) both composed of permanent-magnetic materials and composed of magnetostrictive materials. It goes without saying that, if appropriate, despite the magnetostrictive properties of the layer 34b, an additional magnetostrictive layer (not shown) can be used in the optical element 15.

Besides the correction of the wavefront of the optical element 15, the active layer 34 and/or the magnetizable layer 35 can also be used to compensate for temperature-dictated deformations of the optical element 15 and/or of the substrate 30 which are brought about by a non-uniform temperature distribution in the respective optical elements 13 to 15 and 21 to 24. In this case, the non-uniform temperature distribution typically results from the circumstance that the structured object M (or the reflective mask) has reflective and non-reflective or at least less reflective regions, and that the illumination settings of the illumination system 10 can vary e.g. depending on the mask used. As a result, the reflected EUV radiation is absorbed to a greater or lesser extent in different regions of the structured object M. This leads to the non-uniform temperature distribution or to partly high temperature gradients in the optical elements 13 to 15 and 21 to 24.

In order to compensate for or to eliminate the temperature-dictated deformations, the field generating device 17a, 17b can be designed for inductively heating the optical elements 15, 21 by the generation of a periodically variable magnetic field, e.g. by virtue of the electromagnets 5 or their coils (not shown) being operated by means of a (radio-frequency) generator (not shown) for generating a periodically fluctuating voltage in order to add a dynamic field component to the (quasi) static magnetic field which typically serves for wavefront correction. In this way, it is possible to generate locally eddy currents in those partial regions of the optical elements 15, 21 which are not heated or are heated to a lesser extent by the EUV radiation. The eddy currents lead there to an additional local heating that cancels possibly existing temperature gradients and brings about a homogenization of the temperature profile at the optical elements 15, 21.

The inductive heating of the optical elements 15 shown in figures 2a-c makes use of the fact that a magnetizable layer 35, 34b is present which concentrates the magnetic field generated and increases the efficiency of the inductive heating. If the alternating field component of the magnetic field generated by the field generating device 17a, 17b is chosen to be greater than the static component, the magnetostrictive material of the active layer 34, 34b is remagnetized, which additionally generates heat. However, it should be taken into consideration in this case that the thickness of the active layer 34, 34b likewise changes as a result of the remagnetization, such that in this case - even if the magnetization is not changed - the frequency of the periodically fluctuating magnetic field component should be chosen to be significantly greater than the pulse frequency with which the EUV light source 1 is operated, such that the magnetostrictive change in thickness is averaged by the alternating field component, that is to say that each EUV pulse "sees" the same (average) change in thickness. In the case of the frequencies of the EUV light source that are typically used, the frequency of the alternating field component should be more than 20 kHz, preferably more than 60 kHz. The EUV pulses are typically generated with pulse frequencies in the range of several kHz (e.g. at approximately 20 kHz). However, since an individual EUV pulse has in contrast only a short time duration, the inductive heating can also be effected only in the pauses between successive EUV pulses, such that a respective EUV pulse "sees" no change in thickness.

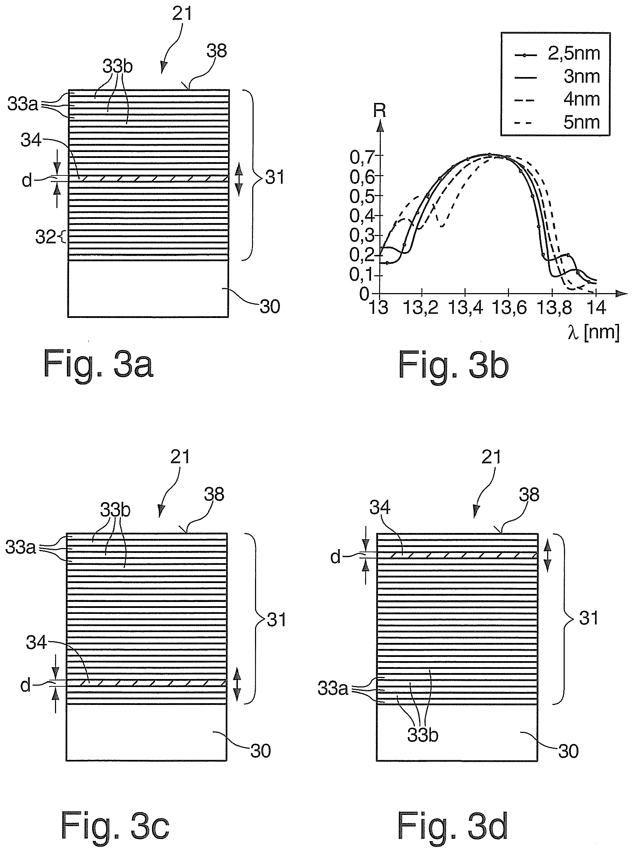

**Figure 3a** illustrates an example of the optical element 21 arranged in the projection lens 20. In the case of the optical element 21, an active layer 34 is not arranged between the reflective coating 31 and the substrate 30, but rather within the reflective coating 31. In the present example, only a single active layer 34 is provided in the reflective coating 31, which is arranged centrally in the reflective coating 31, that is to say that an identical number of layer pairs 32 are situated above and below the active layer 34.

**Figure 3b** shows an illustration of the wavelength-dependent reflectivity (R-λ curve) illustrating the effect of the change in the thickness d of the centrally arranged active layer 34 from figure 3a on the reflectivity of the coating 31. The R-λ curve indicates the reflectivity value (proportion of the reflected relative to the impinging EUV radiation) of the reflective coating 31 from figure 3a against the wavelength of the EUV radiation (here between 13 nm and 14 nm). In this case, the four different lines of the R-λ curve correspond to four different thicknesses of the active layer 34 from d1 = 2.5 nm to d2 = 5 nm. A change in thickness can be brought about, for example, by the variation of the strength of a magnetic field introduced in the region of the optical element 21 by the field generating device 17a, as a result of which the magnetostrictive active layer 34 expands to a greater or lesser extent. By virtue of the central arrangement of the active layer 34 within the reflective coating 31, the resulting reflectivity curve of the reflective coating 31 or of the optical element 21 can be widened or reduced. Furthermore, the line form of the reflectivity curve can thus also be changed.

A similar effect can also be achieved in the case of an optical element 21 as illustrated in **figure 3c**, wherein here the active layer 34 is provided, as in figure 3a, within the reflective coating 31, but in a region in direct proximity to the substrate 30 of the optical element 21. By virtue of this arrangement of the active layer 34 within the reflective coating 31, the resulting reflectivity curve of the reflective coating 31 or of the optical element 21 can likewise be changed, for example widened, in particular the phase also changing. A fine tuning of the reflectivity or of the phase change of the radiation reflected at the optical element 21 is thus possible.

As has already been described further above, the number of high and low refractive index layers 33a, 33b as illustrated in the figures (e.g. 26 layers in figure 3a) should be understood merely as illustrative. Generally, optical elements have between 25 and 60 layer pairs 32, that is to say between 50 and 120 layers composed of high and low refractive index layer material 33a, 33b. If the total number of layers is N = 100, for example, and if the first layer (N = 1) is arranged adjacent to the substrate 30 and the one hundredth layer (N = 100) adjoins a radiation entrance surface 38 forming an interface of the optical element 21 with the environment, then the described effects on the reflectivity curve are obtained if the active layer is arranged between the first layer and the N-5-th layer. In this case, active layers 34 arranged closer to the substrate 30 have a greater effect on the phase of the reflected radiation than on the form of the reflectivity curve, while active layers 34 situated closer to the radiation entrance surface 38 have an influence on the peak form of the reflectivity curve rather than on the phase. It goes without saying that two or more active layers 34 can also be provided in the reflective coating 31 in order to enable a fine tuning of the form of the reflectivity curve or of the phase.

**Figure 3d** shows a further example of an optical element 21. Here, too, an active layer 34 is arranged within the reflective coating 31 as in figures 3a and 3c. However, the active layer 34 is provided in a region in proximity to the radiation entrance surface 38 of the optical element 21, that is to say between the N-th and the N-5-th layer of the reflective coating 31. In the case of such an arrangement below the radiation entrance surface 38, the position of the maximum reflectivity of the reflectivity curve can be influenced without a great change in the form of the reflectivity curve occurring in this case. It goes without saying that all three layers 34 shown in figures 3a, c, d can also be realized in one and the same coating 31 in order to bring about a fine tuning of the optical element 21.

The thickness of the active layer 34 is typically a few nanometers (e.g. between approximately 0.5 nm and approximately 7 nm, in particular between approximately 2 nm and 5 nm). As a result, the magnetostrictive material, which is more highly absorbent in comparison with the materials of the high and low refractive index layers 33a, 33b, can be arranged within the reflective coating 31 without the reflectivity of the optical element 21 being influenced excessively negatively. In particular, the hatching of the active layers 34 in the figures is not intended to indicate that the active layer 34 is non-transmissive to the EUV radiation. It goes without saying that a reflective optical element 21 designed as in figures 3a, c, d can also be used in the illumination system 10 of the lithography apparatus 40 and the reflective optical element from figures 2a-c can be used in the projection lens 20.

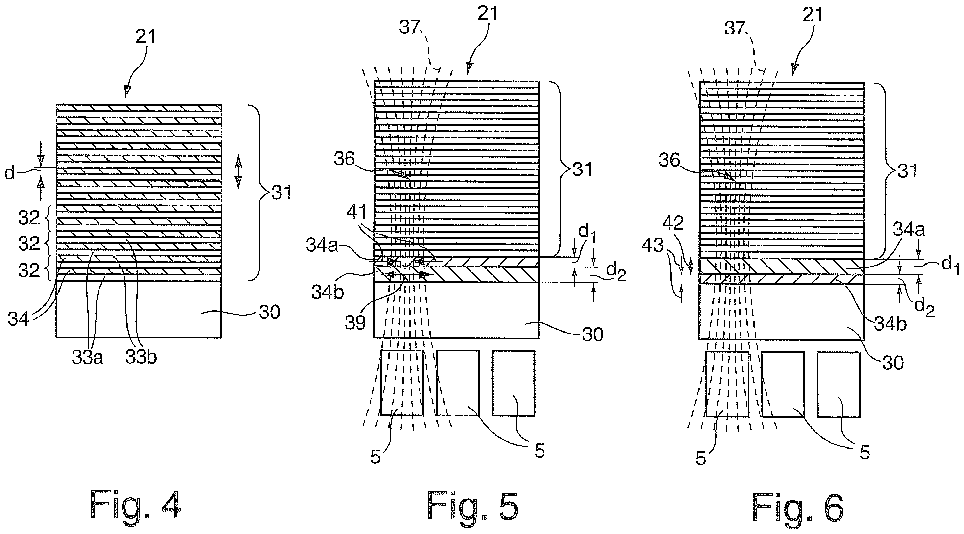

**Figure 4** shows an exemplary embodiment of an optical element 21, wherein in all of the layer pairs 32, an active layer 34 is inserted both between the layer 33a composed of the high refractive index layer material and the layer 33b composed of the low refractive index layer material and above the layer 33a composed of the high refractive index material. In this case, the respective layer pairs 32 have an identical (if appropriate location-dependent) thickness, such that the coating 31 has a periodic structure. By introducing at least one active layer 34 into each layer pair, it is possible to change the maximum wavelength of the reflective coating 34 in a targeted manner. In particular, the maximum wavelength can be locally tuned to the requirements prevailing at a respective position on the mirror 21 or on the substrate 30. Consequently, a local change in the maximum wavelength of the reflectivity curve can be performed by means of the optical element 21. In the case of a positively magnetostrictive material of the active layer 34, by applying the magnetic field it is possible to obtain, for example, an increase in the thickness of the layer pairs 32 and thus a shift in the entire reflectivity curve toward higher wavelengths. The total thickness d of the active layer(s) 34 in the respective layer pair 32 is generally in the sub-nanometer range (that is to say less than approximately 1 nm), in order to prevent the reflectivity of the coating 31 from decreasing to an excessively great extent. It goes without saying that, in contrast to what is shown in figure 4, it is possible to provide only a single active layer 34 in each layer pair 32 in order to achieve a shift in the entire reflectivity curve.

Finally, **figure 5** shows an optical element 21 comprising a substrate 30, a second active layer 34b composed of a negatively magnetostrictive material (e.g. nickel), a first active layer 34b composed of a positively magnetostrictive material (e.g. iron) and a reflective coating 31. Electromagnets 5 of a field generating device are illustrated in the lower region of the optical element 21, one of which electromagnets generates a locally delimited magnetic field 36. As a result of the locally delimited magnetic field 36, the second active layer 34b is expanded in a partial region transversely with respect to the field lines 37 of the magnetic field 36 (expansion 39). At the same time, the first active layer 34a contracts transversely with respect to the magnetic field 36, thus giving rise to (compressive) stresses 41. Through a suitable choice of the thicknesses d₁, d₂ of the active layers 34a, 34b depending on the magnetostrictive constants of the layer materials, it is possible to compensate for the layer stresses that occur locally in the reflective coating 31. In other words, the changes in the stress of the two active layers 34a, 34b that are brought about by the magnetic field 36 mutually compensate for one another. It goes without saying that with the use of a negatively magnetostrictive material as second active layer 34b, the effect is reversed, that is to say that, as a result of the generation of a magnetic field, the second active layer 34b is compressed transversely with respect to the field lines 37 and it is possible to compensate for tensile stresses in the overlying first active layer 34a. It goes without saying that in the case of an orientation of the magnetic field or of the field lines which is rotated by 90° (that is to say that the field lines run substantially parallel to the layer 34 or to the substrate 30), the effect on the stresses that is brought about by the positively or negatively magnetostrictive material is likewise reversed. It goes without saying that the stress compensation can be effected locally as shown in figure 5, but that a stress compensation can also be effected globally, that is to say over the entire substrate surface to which the coating 31 is applied. This can be useful in particular in micromirror arrangements, in order, by changing the layer stress, to change the radius of curvature and thus the focal point of the micromirror in a targeted manner.

**Figure 6** shows an optical element 21 analogous to figure 5, wherein the layer thicknesses d₁, d₂ of the active layers 34a, 34b are chosen such that, rather than the layer stresses, the changes 42, 43 in thickness or length of the two positively and negatively magnetostrictive active layers 34a, 34b precisely compensate for one another. In this way, the application of a magnetic field 36 can be used in a targeted manner (locally) for manipulating the layer stresses, without this having effects on the optical properties (e.g. on the phase) of the optical element 21.

It goes without saying that for stress and/or length compensation, it is also possible, if appropriate, to use a corresponding material mixture of positively and negatively magnetostrictive materials (e.g. conglomerates, etc.) in one and the same layer, that is to say that the positively magnetostrictive layer 34a and the negatively magnetostrictive layer 34b can be realized as a single, common layer whose mixture ratio and local material composition are chosen suitably. It furthermore goes without saying that two or more layers 34a, 34b composed of a positively and respectively negatively magnetostrictive material can also be used for the stress compensation.

## Claims

1. Optical element (21, 15), comprising:
a substrate (30),
a reflective coating (31), and
at least one active layer (34, 34a, 34b) comprising a magnetostrictive material, wherein the reflective coating (31), in particular for the reflection of EUV radiation, comprises a plurality of layer pairs (32) having alternate layers (33a, 33b) composed of a high refractive index layer material and a low refractive index layer material, wherein
the at least one active layer (34) is formed within the reflective coating (31), and the optical element (21) comprises at least one magnetizable layer (35) which comprises a permanent-magnetic material for generating a magnetic field (36, 36b) in the at least one active layer (34, 34a, 34b).

2. Optical element according to claim 1, wherein the reflective coating (31) has a number N of alternate layers (33a, 33b), the first of which is arranged adjacent to the substrate (30) and the N-th of which is arranged adjacent to a surface (38) facing the environment, wherein the at least one active layer (34) is arranged between the first and the N-5-th layer (33a, 33b).

3. Optical element according to either of claims 1 and 2, wherein the reflective coating (31) has a number N of alternate layers (33a, 33b), the first of which is arranged adjacent to the substrate (30) and the N-th of which is arranged adjacent to a surface (38) facing the environment, wherein the at least one active layer (34) is arranged between the N-5-th layer and the N-th layer.

4. Optical element according to any of claims 1 to 3, wherein the thickness (d) of the at least one active layer (34) in the field-free state is between 0.5 nm and 7 nm, preferably between 2 nm and 4 nm.

5. Optical element according to any of the preceding claims, wherein at least one active layer (34) is provided in all of the layer pairs (32).

6. Optical element according to Claim 5, wherein the at least one active layer (34) of a respective layer pair (32) has a thickness (d) of a maximum of 2.5 nm, preferably of a maximum of 1.0 nm.

7. Optical element (21), comprising:
a substrate (30),
a reflective coating (31), and
at least two active layers (34, 34a, 34b) comprising a magnetostrictive material, wherein
the optical element (21) comprises at least one first active layer (34a) comprising a material having positive magnetostriction and at least one second active layer (34b) comprising a material having negative magnetostriction, wherein the layer thicknesses (d1, d2) and the layer materials of the active layers (34a, 34b) are chosen such that mechanical stress changes or changes in length of the active layers (34a, 34b) that are produced by a magnetic field (36, 36b) mutually compensate for one another.

8. Optical element according to claim 7, comprising at least one magnetizable layer (35) which comprises a permanent-magnetic material for generating a magnetic field (36, 36b) in the at least one active layer (34, 34a, 34b).

9. Optical element according to any one of the preceding claims, wherein the permanent-magnetic material of the magnetizable layer (35) is selected from the group comprising: ferrites, samarium-cobalt (Sm-Co), bismanol, neodymium-iron-boron (NdFeB) and steel.

10. Optical element according to any one of the preceding claims, wherein the permanent-magnetic material is magnetostrictive.

11. Optical element according to any one of the preceding claims, wherein the magnetizable layer (35) is arranged between the reflective coating (31) and the substrate (30).

12. Optical element according to any of claims 7 to 11, wherein the at least two active layers (34, 34a, 34b) are arranged between the reflective coating (31) and the substrate (30).

13. Optical element according to any of the preceding claims, wherein the magnetostrictive material of the active layer (34, 34a, 34b) is selected from the group comprising: SeFe₂, TbFe₂, DyFe₂, Terfenol-D (Tb₍ₓ₎ Dy₍₁₋ₓ₎Fe₂), galfenol (Ga₍ₓ₎ Fe₍₁₋ₓ₎), Ni, Fe, Co, Gd, Er, SmFe₂, Samfenol-D and compositions thereof.

14. Optical arrangement (40), in particular EUV lithography apparatus, comprising at least one optical element (15, 21) according to any of the preceding claims.

15. Optical arrangement according to Claim 14, further comprising:
a field generating device (17a, 17b) for generating a magnetic field (36; 36b), which is variable in particular in a location-dependent manner, in the at least one active layer (34).

16. Optical arrangement according to Claim 15, wherein the field generating device (17a, 17b) is designed for inductively heating the at least one active layer (34, 34a, 34b) and/or the at least one magnetizable layer (35) by generating a periodically variable magnetic field (36, 26b).

17. Optical arrangement according to Claim 15, wherein the field generating device (17a, 17b) is designed for generating a magnetic field that is periodically variable with a frequency (f) of more than 20 kHz.

## Patentansprüche

1. Optisches Element (21, 15), Folgendes umfassend:
ein Substrat (30),
eine reflektierende Beschichtung (31), und
mindestens eine aktive Schicht (34, 34a, 34b), ein magnetostriktives Material umfassend, wobei die reflektierende Beschichtung (31), insbesondere für die Reflexion von EUV-Strahlung, mehrere Schichtpaare (32) mit abwechselnden Schichten (33a, 33b) umfasst, die aus einem Schichtmaterial mit hohem Brechungsindex und einem Schichtmaterial mit niedrigem Brechungsindex zusammengesetzt sind, wobei
die mindestens eine aktive Schicht (34) innerhalb der reflektierenden Beschichtung (31) ausgebildet ist und das optische Element (21) mindestens eine magnetisierbare Schicht (35) umfasst, die ein permanentmagnetisches Material zum Erzeugen eines Magnetfelds (36, 36b) in der mindestens einen aktiven Schicht (34, 34a, 34b) umfasst.

2. Optisches Element nach Anspruch 1, wobei die reflektierende Beschichtung (31) eine Anzahl N abwechselnder Schichten (33a, 33b) aufweist, deren erste dem Substrat (30) benachbart angeordnet ist und deren N-te einer Oberfläche (38) benachbart angeordnet ist, die der Umgebung gegenübersteht, wobei die mindestens eine aktive Schicht (34) zwischen der ersten und der N-5-ten Schicht (33a, 33b) angeordnet ist.

3. Optisches Element nach einem der Ansprüche 1 und 2, wobei die reflektierende Beschichtung (31) eine Anzahl N abwechselnder Schichten (33a, 33b) aufweist, deren erste dem Substrat (30) benachbart angeordnet ist und deren N-te einer Oberfläche (38) benachbart angeordnet ist, die der Umgebung gegenübersteht, wobei die mindestens eine aktive Schicht (34) zwischen der N-5-ten Schicht und der N-ten Schicht angeordnet ist.

4. Optisches Element nach einem der Ansprüche 1 bis 3, wobei die Dicke (d) der mindestens einen aktiven Schicht (34) in dem feldfreien Zustand zwischen 0,5 nm und 7 nm, vorzugsweise zwischen 2 nm und 4 nm, ist.

5. Optisches Element nach einem der vorhergehenden Ansprüche, wobei mindestens eine aktive Schicht (34) in allen Schichtpaaren (32) bereitgestellt ist.

6. Optisches Element nach Anspruch 5, wobei die mindestens eine aktive Schicht (34) eines jeweiligen Schichtpaares (32) eine Dicke (d) von maximal 2,5 nm, vorzugsweise von maximal 1,0 nm, aufweist.

7. Optisches Element (21), Folgendes umfassend:
ein Substrat (30),
eine reflektierende Beschichtung (31), und
mindestens zwei aktive Schichten (34, 34a, 34b), die ein magnetostriktives Material umfassen, wobei
das optische Element (21) mindestens eine erste aktive Schicht (34a), die Material mit positiver Magnetostriktion umfasst, und mindestens eine zweite aktive Schicht (34b) umfasst, die ein Material mit negativer Magnetostriktion umfasst, wobei die Schichtdicken (d1, d2) und die Schichtmaterialien der aktiven Schichten (34a, 34b) derartig ausgewählt sind, dass mechanische Spannungsänderungen oder Längenänderungen der aktiven Schichten (34a, 34b), die durch ein Magnetfeld (36, 36b) erzeugt werden, sich untereinander gegenseitig kompensieren.

8. Optisches Element nach Anspruch 7, mindestens eine magnetisierbare Schicht (35) umfassend, die ein permanentmagnetisches Material zum Erzeugen eines Magnetfelds (36, 36b) in der mindestens einen aktiven Schicht (34, 34a, 34b) umfasst.

9. Optisches Element nach einem der vorhergehenden Ansprüche, wobei das permanentmagnetische Material der magnetisierbaren Schicht (35) aus der Gruppe ausgewählt ist, umfassend: Ferrite, Samarium-Kobalt (Sm-Co), Bismanol, Neodym-Eisen-Bor (NdFeB) und Stahl.

10. Optisches Element nach einem der vorhergehenden Ansprüche, wobei das permanentmagnetische Material magnetostriktiv ist.

11. Optisches Element nach einem der vorhergehenden Ansprüche, wobei die magnetisierbare Schicht (35) zwischen der reflektierenden Beschichtung (31) und dem Substrat (30) angeordnet ist.

12. Optisches Element nach einem der Ansprüche 7 bis 11, wobei die mindestens zwei aktiven Schichten (34, 34a, 34b) zwischen der reflektierenden Beschichtung (31) und dem Substrat (30) angeordnet sind.

13. Optisches Element nach einem der vorhergehenden Ansprüche, wobei das magnetostriktive Material der aktiven Schicht (34, 34a, 34b) aus der Gruppe ausgewählt ist, Folgendes umfassend: SeFe₂, TbFe₂, DyFe₂, Terfenol-D (Tb₍ₓ₎Dy₍₁₋ₓ)Fe₂), Galfenol (Ga₍ₓ₎Fe₍₁₋ₓ₎), Ni, Fe, Co, Gd, Er, SmFe₂, Samfenol-D und Zusammensetzungen davon.

14. Optische Anordnung (40), insbesondere EUV-Lithografievorrichtung, mindestens ein optisches Element (15, 21) nach einem der vorhergehenden Ansprüche umfassend.

15. Optische Anordnung nach Anspruch 14, weiterhin Folgendes umfassend:
eine felderzeugende Vorrichtung (17a, 17b) zum Erzeugen eines Magnetfelds (36; 36b), das insbesondere in einer ortsabhängigen Weise variabel ist, in der mindestens einen aktiven Schicht (34).

16. Optische Anordnung nach Anspruch 15, wobei die felderzeugende Vorrichtung (17a, 17b) zum induktiven Erhitzen der mindestens einen aktiven Schicht (34, 34a, 34b) und/oder der mindestens einen magnetisierbaren Schicht (35) durch Erzeugen eines periodisch variablen Magnetfelds (36, 26b) entworfen ist.

17. Optische Anordnung nach Anspruch 15, wobei die felderzeugende Vorrichtung (17a, 17b) zum Erzeugen eines Magnetfelds entworfen ist, das mit einer Frequenz (f) von mehr als 20 kHz periodisch variabel ist.

## Revendications

1. Elément optique (21, 15), comprenant :
un substrat (30),
un revêtement réfléchissant (31), et
au moins une couche active (34, 34a, 34b) comprenant un matériau magnétostrictif, le revêtement réfléchissant (31), en particulier pour la réflexion du rayonnement EUV, comprenant une pluralité de paires de couches (32) ayant des couches alternées (33a, 33b) composées d'un matériau de couche à fort indice de réfraction et d'un matériau de couche à faible indice de réfraction,
l'au moins une couche active (34) étant formée à l'intérieur du revêtement réfléchissant (31), et l'élément optique (21) comprenant au moins une couche aimantable (35) qui comprend un matériau magnétique permanent destiné à générer un champ magnétique (36, 36b) dans l'au moins une couche active (34, 34a, 34b).

2. Elément optique selon la revendication 1, dans lequel le revêtement réfléchissant (31) a un nombre N de couches alternées (33a, 33b), dont la première est disposée adjacente au substrat (30) et dont la N^{ième} est disposée adjacente à une surface (38) faisant face à l'environnement, l'au moins une couche active (34) étant disposée entre la première et la (N-5)^{ième} couche (33a, 33b) .

3. Elément optique selon l'une ou l'autre des revendications 1 et 2, dans lequel le revêtement réfléchissant (31) a un nombre N de couches alternées (33a, 33b), dont la première est disposée adjacente au substrat (30) et dont la N^{ième} est disposée adjacente à une surface (38) faisant face à l'environnement, l'au moins une couche active (34) étant disposée entre la (N-5)^{ième} couche et la N^{ième} couche.

4. Elément optique selon l'une quelconque des revendications 1 à 3, dans lequel l'épaisseur (d) de l'au moins une couche active (34) dans l'état sans champ se situe entre 0,5 nm et 7 nm, de préférence entre 2 nm et 4 nm.

5. Elément optique selon l'une quelconque des revendications précédentes, dans lequel au moins une couche active (34) est prévue dans toutes les paires de couches (32).

6. Élément optique selon la revendication 5, dans lequel l'au moins une couche active (34) d'une paire de couches respective (32) a une épaisseur (d) d'un maximum de 2,5 nm, de préférence d'un maximum de 1,0 nm.

7. Elément optique (21), comprenant :
un substrat (30),
un revêtement réfléchissant (31), et
au moins deux couches actives (34, 34a, 34b) comprenant un matériau magnétostrictif,
l'élément optique (21) comprenant au moins une première couche active (34a) comprenant un matériau ayant une magnétostriction positive et au moins une deuxième couche active (34b) comprenant un matériau ayant une magnétostriction négative, les épaisseurs de couche (d1, d2) et les matériaux de couche des couches actives (34a, 34b) étant choisis de telle sorte que des changements de contrainte mécanique ou des changements de longueur des couches actives (34a, 34b) qui sont produites par un champ magnétique (36, 36b) se compensent mutuellement.

8. Élément optique selon la revendication 7, comprenant au moins une couche aimantable (35) qui comprend un matériau magnétique permanent destiné à générer un champ magnétique (36, 36b) dans l'au moins une couche active (34, 34a, 34b).

9. Élément optique selon l'une quelconque des revendications précédentes, dans lequel le matériau magnétique permanent de la couche aimantable (35) est choisi dans le groupe comprenant : les ferrites, le samarium-cobalt (Sm-Co), le bismanol, le néodyme-fer-bore (NdFeB) et l'acier.

10. Élément optique selon l'une quelconque des revendications précédentes, dans lequel le matériau magnétique permanent est magnétostrictif.

11. Élément optique selon l'une quelconque des revendications précédentes, dans lequel la couche aimantable (35) est disposée entre le revêtement réfléchissant (31) et le substrat (30).

12. Élément optique selon l'une quelconque des revendications 7 à 11, dans lequel les au moins deux couches actives (34, 34a, 34b) sont disposées entre le revêtement réfléchissant (31) et le substrat (30).

13. Élément optique selon l'une quelconque des revendications précédentes, dans lequel le matériau magnétostrictif de la couche active (34, 34a, 34b) est choisi dans le groupe comprenant : SeFe₂, TbFe₂, DyFe₂, le Terfenol-D (Tb₍ₓ₎Dy₍₁₋ₓ₎Fe₂), le galfenol (Ga₍ₓ₎Fe_{(1-X)}), Ni, Fe, Co, Gd, Er, SmFe₂, le Samfenol-D et les compositions de ceux-ci.

14. Agencement optique (40), en particulier appareil de lithographie EUV, comprenant au moins un élément optique (15, 21) selon l'une quelconque des revendications précédentes.

15. Agencement optique selon la revendication 14, comprenant en outre :
un dispositif générant un champ (17a, 17b) destiné à générer un champ magnétique (36 ; 36b), qui est variable, en particulier d'une manière dépendante de l'emplacement, dans l'au moins une couche active (34).

16. Agencement optique selon la revendication 15, dans lequel le dispositif générant un champ (17a, 17b) est conçu pour chauffer par induction l'au moins une couche active (34, 34a, 34b) et/ou l'au moins une couche aimantable (35) en générant un champ magnétique à variation périodique (36, 26b).

17. Agencement optique selon la revendication 15, dans lequel le dispositif générant un champ (17a, 17b) est conçu pour générer un champ magnétique qui présente une variation périodique avec une fréquence (f) de plus de 20 kHz.
